# EUROPEAN PATENT APPLICATION

(11) **EP 1 271 578 A2**
(43) Date of publication of application: **02.01.2003**
(21) Application number: 02011838.6
(22) Date of filing: 28.05.2002
(51) Int. Cl.: H01G 4/20

(54) **Thermosetting composite dielectric film and method of manufacturing the same**

(30) Priority: 29.05.2001 JP 2001161377
(71) Applicant: Nippon Paint Co., Ltd., Osaka-shi, Osaka 531-8511 (JP)
(72) Inventor: Tadashi, Hayashi, Toyonaka-shi, Osaka 560-0011 (JP); Mamoru, Seio, Takatsuki-shi, Osaka 569-1046 (JP)
(74) Representative: Merkle, Gebhard

(57) **Abstract**

A thermosetting composite dielectric film characterized in that the film has flexibility and is made of a thermosetting resin such as an epoxy resin having an epoxy equivalent of 150 to 2500 and containing dielectric ceramics having a high dielectric constant and in that the film has a dielectric constant of 25 or more.

## Description

### BACKGROUND OF THE INVENTION

### FIELD OF THE INVENTION

The present invention relates to a dielectric film capable of being formed into a capacitor by being incorporated into a substrate such as a printed wiring board and to a method for its manufacture.

### RELATED ART

For responding to the demand of electronic instruments for downsizing, thinning and greater packing density, multilayer boards have come to be used in printed wiring boards. If a high-dielectric layer is formed as an internal or surface layer of such a multilayer board, it is possible to utilize the layer as a capacitor, thereby improving packaging density. However, since conventional high-dielectric materials are sintered ceramic compacts obtained by forming and subsequent burning of a ceramic powder, their size and shape are restricted by the forming method. Further, since sintered compacts are of high hardness and fragility, it is difficult to form them freely and it is not necessarily easy to obtain a desired shape or a complex shape.

For solving the above problems, attention is being given to composite dielectric substances obtained by dispersing particles of an inorganic dielectric substance in a resin and patent applications about such composite dielectric substances have been filed. For example, in Japanese Patent Publication No.49-25159, it is prepared a dielectric paint obtained by mixing a barium titanate powder in an epoxy resin. However, since films obtained from such dielectric paints are fragile and difficult-to-handle, the films have problems of being poor in workability, mass-productivity and impact resistance.

In Japanese Patent Laid Open No.55-148308, it is disclosed a high-dielectric composition obtained by adding a dielectric powder of ceramics to a thermosetting resin and a capacitor using the same is referred to as an example. However, since glass fibers must be blended, there is a practical problem that a capacity sufficient as a capacitor cannot be obtained. Further, in Japanese Patent Laid Open No.55-57212, Japanese Patent Laid Open No.61-136281, Japanese Patent Laid Open No.5-415 and Japanese Patent Publication No.2740357, they manufactured a high-dielectric laminated board by the following steps: preparing a plurality of prepregs by blending a high-dielectric inorganic powder such as barium titanate into a composition of resin such as epoxy resin or modified thermosetting polyphenylene oxide resin, impregnating a fiber reinforcement such as glass cloth with the obtained blend, and drying; stacking the obtained prepregs; and providing a copper foil as an outermost layer of the stack. However, since a fiber reinforcement such as glass cloth is used in such a method, the thickness cannot be reduced, resulting in the problem that large capacity cannot be obtained.

In Japanese Patent Publication No. 2802173, it is disclosed a composite dielectric substance obtained by dispersing a porous inorganic dielectric powder in a resin. However, in the case of this composite dielectric substance, it is necessary to cure the substance, pulverize the cured substance, and form the pulverized substance at high temperature under pressure. From the viewpoints of heat resistance and pressure resistance, there is a restriction on a substrate into which a capacitor is incorporated.

In Japanese Patent Laid Open No.9-12742, it is disclosed a high-dielectric film comprising an inorganic powder and a thermosetting resin. However, it could not provide a sufficient dielectric constant. Considering the incorporation to a printed wiring board, films having higher dielectric constants are required.

As described above, the attempt to improve electric characteristics required as a capacitor by using a conventional composite dielectric substance results in insufficient handleability, workability, productivity and physical characteristics such as impact resistance. On the other hand, the attempt to improve such physical characteristics results in insufficient electric characteristics for a capacitor.

### SUMMARY OF THE INVENTION

The object of the present invention is to provide a dielectric film capable of being formed into a capacitor by being incorporated into a substrate such as a printed wiring board and a method for its manufacture.

The present invention is a thermosetting composite dielectric film having flexibility comprising a thermosetting resin containing dielectric ceramics having a high dielectric constant, wherein the composite dielectric film has a dielectric constant of 25 or more.

The composite dielectric film of the present invention has a dielectric constant of 25 or more, preferably 30 or more, more preferably 40 or more. The composite dielectric film of the present invention is capable of being formed into a capacitor with large capacity because of such a high dielectric constant. Further, since it is a flexible composite dielectric film, it can be handled easily when being incorporated into a substrate and can be incorporated even into a flexible substrate.

Furthermore, the composite dielectric film of the present invention has flexibility even after its thermal curing. Hence it shows good workability, for example, a hole can be formed in the film after its incorporation into a substrate and the like.

It is preferable that the composite dielectric film of the present invention has a dielectric loss of 5% or less, more preferably 3% or less.

As the thermosetting resin in the present invention, an epoxy resin having at least one epoxy group in its molecule is preferably employed.

The aforementioned epoxy resin is not particularly restricted as long as it is an epoxy resin having at least one epoxy group in its molecule, and is exemplified by glycidyl ether type epoxy resins, for example, glycidyl ether of bisphenol A, glycidyl ether of bisphenol F, glycidyl ether of bisphenol AD, glycidyl ether of resorcin, glycidyl ether of glycerin, glycidyl ether of polyalkylene oxide, glycidyl ether of brominated bisphenol A, oligomers thereof; epoxidized products of condensates of phenols, orthocresols and/or naphthols or the like and formalins, aliphatic or aromatic aldehydes or ketones, typified by glycidyl ether of phenol novolac and the like; stilbene type epoxy resins, biphenyl type epoxy resins, alicyclic epoxy resins such as alicyclic diepoxyacetal, alicyclic diepoxyadipate and alicyclic diepoxycarboxylate; and linear aliphatic epoxy resins typified by epoxidized polybutadiene. Examples of other epoxy resins include glycidyl ester type epoxy resins, for example, diglycidyl phthalate ester, diglycidyl tetrahydrophthalate ester and diglycidyl hexahydrophthalate ester and the like; glycidylamine type epoxy resins, for example, N,N-diglycidylaniline and tetraglycidylaminodiphenylmethane; heterocyclic epoxy resins, hydantoin type epoxy resins, triglycidyl isocyanurate, silicone-modified epoxy resins, urethane-modified epoxy resins, and polyimide- or polyamide-modified epoxy resins. These epoxy resins may be used in combination.

As above-described epoxy resin in the present invention, an epoxy resin having an epoxy equivalent of 150 to 2500 is particularly preferable. If the epoxy equivalent is less than 150, the flexibility of a film may be deteriorated and the film may be poor in handleability, workability, impact resistance and the like. Further, if the epoxy equivalent is over 2500, the crosslinking density of a film may become too low and the physical strength of the film may be reduced.

As described above, the epoxy equivalent of the epoxy resin in the present invention is preferably from 150 to 2500. Hence, for example, in the case of a resin having one epoxy group in its molecule, its molecular weight is preferably from 150 to 2500. In the case of a resin having two epoxy groups in its molecule, its molecular weight is preferably from 300 to 5000. In the case of a resin having three epoxy groups in its molecule, its molecular weight is preferably from 450 to 7500.

A bisphenol-epichlorohydrin type epoxy resin having a chalcone group may be used as the above-described epoxy resin in the present invention. Use of such a bisphenol-epichlorohydrin type epoxy resin can make the dielectric constant of a composite dielectric film higher to further reduce the dielectric loss of the film.

The bisphenol-epichlorohydrin type epoxy resin means a resin having a unit obtainable by subjecting a bisphenol type compound represented by the general formula, below: 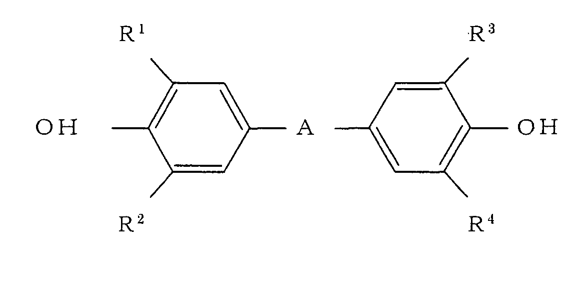 (in the formula, R¹, R², R³ and R⁴ may be identical to or different from one another and independently represent a hydrogen atom, an alkyl group having from 1 to 4 carbon atoms, or a halogen atom, and A represents ―O―, ―CH₂―, ―C(CH₃)₂―, ―CO―, ―C(CF₃)₂ ―, Si(CH₃)₂ ― or 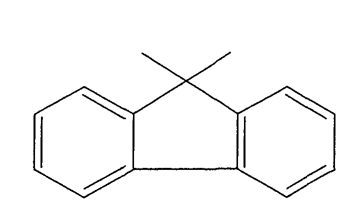 or means that one phenyl group and another phenyl group are bonded together directly) and epichlorohydrin to ring-opening addition. Since a chalcone group is a benzalacetophenone group and has a characteristic that functional groups of the same kind react via a photoradical reaction to undergo photopolymerization, that group serves also as a photosensitive functional group. For this reason, when a chalcone group-containing bisphenol-epichlorohydrin type epoxy resin is used as an epoxy resin, a film can be patterned by light irradiation.

The aforementioned chalcone group-containing bisphenol-epichlorohydrin type epoxy resin preferably has a weight average molecular weight of 8000 to 40000. If the weight average molecular weight is less than 8000, when patterning is carried out by light irradiation the irradiated portion is made hard to become insoluble in a developing solution and hence image contrast may become poor. On the other hand, if the weight average molecular weight is over 40000, when patterning is carried out by light irradiation, the portion not irradiated is made hard to be dissolved in a developing solution and hence image contrast may become poor.

The content of chalcone groups in the aforementioned bisphenol-epichlorohydrin type epoxy resin is preferably from 0.1 to 1 mole/kg. If the content of chalcone groups is less than 0.1 mole/kg, when patterning is carried out by light irradiation, there is a possibility that no photo crosslinking reaction may proceed, resulting in poor image contrast. On the other hand, if the content of chalcone groups is over 1 mole/kg, the flexibility may be deteriorated and handleability, workability, impact resistance and the like may become poor.

The content of epoxy groups in the aforementioned bisphenol-epichlorohydrin type epoxy resin is preferably from 0.5 to 1.5 mole/kg. If the content of epoxy groups is less than 0.5 mole/kg, the physical strength may be reduced because of less crosslinking. On the other hand, if the content of epoxy groups is over 1. 5 mole/kg, the flexibility may be deteriorated and handleability, workability, impact resistance and the like may become poor because of excess crosslinking.

The epoxy resin to be used as a thermosetting resin in the present invention may contain a low-viscosity epoxy resin. Blending a low-viscosity epoxy resin allows a composite dielectric film to have good flexibility. Examples of the low-viscosity epoxy resin include resins having a viscosity of 1000 Pa·s or lower at 25°C. As such epoxy resins, there can be recited those having a viscosity within the range mentioned above selected from the above resins listed as an epoxy resin having at least one epoxy group in its molecule.

In the present invention, a curing agent is added, as needed, to the thermosetting resin. When an epoxy resin is used as the thermosetting resin, a curing agent generally employed as a curing agent for epoxy resin may be added thereto. Such a curing agent is exemplified by amine type curing agents, acid anhydride type curing agents and phenol type curing agents. Specific examples thereof include aliphatic amines and aliphatic polyamines, such as diethylenetriamine and triethylenetetramine; aliphatic polyamines having an aromatic ring; alicyclic and cyclic polyamines; aromatic amines, such as diaminediphenylsulfone; aliphatic acid anhydrides; alicyclic acid anhydrides; aromatic acid anhydrides; halogen-type acid anhydrides; trisphenols; phenol novolac; cresol novolac; bisphenol A novolac; bisphenol F novolac; phenols-dicyclopentadiene polyaddition type resins; dihydroxynaphthalene novolac; polyhydric phenols having xylidene as a binding group; phenol-aralkyl resins, naphthols, polyamide resins and modified products thereof; methylol group-containing initial condensates obtained by allowing phenol, urea, melamine or the like to react with formalin; basic active hydrogen compounds typified by dicyandiamide; tertiary amines such as tris (dimethylaminomethyl)phenol; salts of Lewis acids and Brönsted acids, such as imidazole, BF₃-amine complexes; polymercaptan type curing agents; isocyanates or block isocyanates; and organic acid dihydrazides. Further, these curing agents may be used in combination.

As the dielectric ceramics having a high dielectric constant to be contained in the thermosetting resin, dielectric ceramics having a dielectric constant of at least 200 as measured using their simple substances are preferred. For example, barium titanate (BaTiO₃), calcium titanate (CaTiO₃), strontium titanate (SrTiO₃), lead titanate based ceramics, such as lead titanate (PbTiO₃) and PbTi_{1/2}Zr_{1/2}O₃, magnesium titanate based ceramics, bismuth titanate based ceramics, other metal titanate based ceramics, Pb(Mg_{2/3}Nb_{1/3}) O₃, Ba(SnₓMg_{y}Ta_{z}) O₃, Ba(ZrₓZn_{y}Ta_{z})O₃, TiO₂, ZrO₂, SnO₂, aluminum oxide based ceramics, zirconium oxide based ceramics, lead zirconate based ceramics, barium zirconate based ceramics, other metal zirconate based ceramics, lead composite oxide based ceramics, and other known dielectric ceramics having a high dielectric constant are listed. It is possible to use either a single kind of dielectric ceramics having a high dielectric constant or multiple kinds of dielectric ceramics having a high dielectric constant in combination. Further, dielectric ceramics having a high dielectric constant treated with an inorganic or organic substance may be used. The dielectric ceramics may be in a spherical shape or in various block-like shapes and are not restricted with respect to their shape.

In the present invention, the content of the dielectric ceramics in the thermosetting resin is preferably from 20 to 70 volume%. If the content of the dielectric ceramics is less than 20 volume%, no high dielectric constant can be obtained in some cases. If the content of the dielectric ceramics is over 70 volume%, no good flexibility can be obtained in some cases. It is to be noted that in the present invention the flexibility refers to flexibility such that, for example, a specimen of a composite dielectric film 20 cm long and 70 µm thick can be bent so that the both ends of the film make together an angle of 90 degrees. Further, it is preferable that a composite dielectric film after curing also has such flexibility.

The average particle diameter of the dielectric ceramics preferably ranges from 0.1 to 10 µm. If the average particle diameter of the dielectric ceramics is less than 0.1 µm, an insufficient improvement in dielectric constant of a composite dielectric film may be achieved by incorporation of the dielectric ceramics. If the average particle diameter of the dielectric ceramics is over 10 µm, it becomes difficult to disperse and mix the dielectric ceramics uniformly into a resin, resulting in appearance of unevenness caused by particles in the surface of the composite dielectric film and in deterioration of smoothness of the surface of the film. As a result, poor adhesiveness to a substrate may be obtained and variation in dielectric characteristics may be caused.

The manufacturing method of the present invention is a method by which the aforementioned thermosetting composite dielectric substance-containing film of the present invention can be manufactured. The method is characterized by comprising the steps of applying a solution of a thermosetting resin containing dielectric ceramics having a high dielectric constant onto a base material, and drying the resultant at a temperature lower than the curing temperature of the thermosetting resin to form the resultant into a film.

As the base material, for example, a plastic film having a surface to which release treatment has been applied can be used. When a solution of a thermosetting resin containing dielectric ceramics is applied to a release-treated plastic film and then is formed into a film, the resulting film is generally used after released from the base material.

Examples of the plastic film that can be used as the base material include a polyethylene terephthalate (PET) film, a polyethylene film, a polypropylene film, a polyester film, a polyimide film, and films of aramid, Kapton and polymethylpentene and the like. It is preferable to use, as the plastic film, those insoluble in the organic solvent contained in the thermosetting resin solution.

The thickness of a plastic film to be used as a base material is preferably from 1 to 100 µm, more preferably from 1 to 40 µm.

As the release treatment to be applied to a surface of a base material, a release treatment comprising application of silicone, wax, fluororesin or the like to the surface is preferably employed.

Further, a dielectric film can also be formed on a metal foil, which is used as a base material. In such a case, the metal foil used as a base material can be used as an electrode of capacitor.

A method for applying a thermosetting resin solution to a base material is not particularly restricted and general application methods can be employed. For example, it can be applied by a roller method, a spray method, a silk-screen method or the like.

In the manufacturing method of the present invention, since a film is formed by drying at a temperature lower than the curing temperature of the thermosetting resin, the resulting composite dielectric film is in a state before curing. It, therefore, is more flexible than that in a state after curing and is easy to be handled. Such a dielectric film can be heat-cured by being heated after its incorporation into a substrate such as a printed wire board. In the case where a photosensitive resin is used, patterning can be performed through selective light exposure.

A method for manufacturing a composite dielectric film of the present invention is not restricted to the above-described manufacturing method of the present invention and other methods may be used. For example, the composite dielectric film may be formed on a film by extrusion of a thermosetting resin composition containing dielectric ceramics, for example, by a calender method and the like. Alternatively, it is also possible to form the thermosetting resin composition into a film form by heating it to a temperature higher than the curing temperature of the thermosetting resin.

A dielectric film extrusion-formed may also be formed so as to be extruded onto the above-described base material.

When a metal foil is used as the base material, foils made of copper, brass, nickel, iron and the like, foils of alloys of these metals, composite foils and the like may also be used. To such a metal foil, treatment of surface roughening, treatment of applying adhesive, or the like may be applied as needed.

After application of the aforementioned thermosetting resin solution onto a metal foil, it is preferable to dry at a temperature lower than the curing temperature of the thermosetting resin. Also in the case of extrusion of a thermosetting resin composition, it is preferable to extrude and dry at a temperature lower than the curing temperature of the thermosetting resin.

Further, a dielectric film may be formed between metal foils. In such a case, a dielectric film sandwiched between metal foils may also be formed by applying a thermosetting resin solution onto a metal foil followed by putting thereon another metal foil, and drying the resultant while sandwiching the thermosetting resin solution between the metal foils. Moreover, a dielectric film disposed between metal foils may also be formed by extrusion of a thermosetting resin composition so that the composition is sandwiched between the metal foils.

The thermosetting resin composition of the present invention for forming a composite dielectric film is a thermosetting resin composition used in the above-described composite dielectric film of the present invention. Specifically, the thermosetting resin composition is characterized in that an epoxy resin having an epoxy equivalent of 150 to 2500 contains dielectric ceramics having an average particle diameter of 0.1 to 10 µm blended in an amount of 20 to 70 volume%.

As the epoxy resin, epoxy resins that can be used for the above-described composite dielectric film of the present invention are used. Hence such an epoxy resin is exemplified by a bisphenol-epichlorohydrin type epoxy resin having a chalcone group and having a weight average molecular weight of 8000 to 40000.

The epoxy resin may contain a low-viscosity epoxy resin. Examples of such a low-viscosity epoxy resin include epoxy resins having a viscosity of 1000 Pa·s or lower at 25°C as described above.

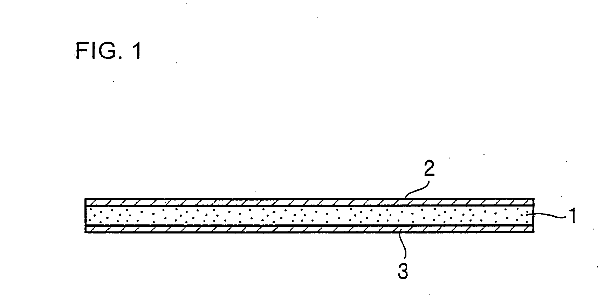

Fig. 1 is a sectional view illustrating a state where electrodes are provided on both surfaces of a composite dielectric film according to the present invention. As shown in Fig. 1, an electrode 2 and another electrode 3 are provided on both surfaces of a composite dielectric film 1. The electrodes 2 and 3 may be made of metal foils as described above and also may be formed on the composite dielectric film 1 by a plating technique. Further, one may form a metal film by a thin film forming technique and use it as an electrode.

As shown in Fig. 1, a capacitor can be formed by providing electrodes 2 and 3 on both surfaces of a composite dielectric film 1. By forming the electrodes 2 and 3 in a predetermined pattern, a capacitor having a desired capacity in a desired site can be formed.

### BRIEF DESCRIPTION OF THE DRAWINGS

Fig. 1 is a sectional view that illustrates a state where electrodes are provided on both surfaces of a composite dielectric film according to the present invention.

### DESCRIPTION OF THE PREFERRED EMBODIMENTS

The present invention is described in more detail below with reference to examples. The present invention, however, is not restricted to the examples at all and can be carried out along with suitable modifications unless the gist thereof is changed.

### (Example 1)

A thermosetting composite dielectric composition was prepared by stirring, at a room temperature and an atomospheric pressure for 30 minutes using an Ishikawa type stirring crusher, a solution obtained by dissolving 14.78 g of an epoxidized thermoplastic elastomer (commercial name "EPOFRIEND A1020" manufactured by DAICEL CHEMICAL INDUSTRIES, LTD., epoxy equivalent : 480-540) as a thermosetting resin in 44.10 g of toluene, 0.30 g of 2,4-diamino-6-(2'-methylimidazolyl-(1'))-ethyl-s-triazine as a curing catalyst and 62.83 g of barium titanate (particle diameter : 1.16 µm) as dielectric ceramics having a high dielectric constant.

A thermosetting composite dielectric film was prepared by applying, with an 8-mil (1 mil = 1/1000 inch) doctor blade, the thermosetting composite dielectric composition obtained above to a 25 µm thick polyethyleneterephthalate film a surface of which had been release-treated with silicone, leaving to stand at room temperature for 30 minutes, drying at 70°C for 30 minutes using a hot-air dryer, and subsequently drying at 90°C for 30 minutes.

The amount of the residual solvent in that thermosetting composite dielectric film was measured by gas chromatography and was found to be less than 1 wt.%. The content of barium titanate in the thermosetting composite dielectric film was 41.2 volume%.

A ruler was applied to the thermosetting composite dielectric film and the film was bent from its flat condition, but no cracks appeared even the bending angle exceeded 90 degrees. This fact confirmed that the film had good flexibility. Further, the thermosetting composite dielectric film was heated at 190°C for 1 hour to be cured. As for the composite dielectric film after curing, its specimen 20 cm long was bent so that its both ends made an angle of 90 degrees, but no cracks appeared. This fact also confirmed that the film had good flexibility. The composite dielectric film after curing has found to have a thickness of about 70 µm.

For measurement of the dielectric constant and dielectric loss (tan δ) of the thermosetting composite dielectric film, the above-described thermosetting composite dielectric composition was applied to a 0.5 mm thick copper plate (JIS H 3100, C1100P) using an 8-mil doctor blade and was left to stand at room temperature for 30 minutes. After being dried at 70°C for 30 minutes and subsequently at 90°C for 30 minutes in a hot-air dryer, the thermosetting composite dielectric composition was cured by being heated at 190°C for 1 hour in a hot-air dryer. Gold was deposited onto the cured composite dielectric film, and then the dielectric constant and dielectric loss of the film in the range of 100 Hz to 10 MHz were measured with Impedance/Gain-Phase Analyzer (4194A manufactured by Yokogawa Hewlett-Packard Co.) using a copper plate and the gold-deposited film as electrodes. The results obtained at 1 KHz are shown in Table 1.

### (Example 2)

A thermosetting composite dielectric composition was prepared by stirring, at a room temperature and an atomospheric pressure for 30 minutes using an Ishikawa type stirring crusher, a solution obtained by dissolving 22.60 g of epoxidized polybutadiene (commercial name "EPOLEAD PB3600" manufactured by DAICEL CHEMICAL INDUSTRIES, LTD., epoxy equivalent : 188-213, viscosity at 25°C : 100-200 Pa·s) as a thermosetting resin in 11.30 g of methyl ethyl ketone, 0.45 g of 2,4-diamino-6-(2'-methylimidazolyl-(1'))-ethyl-s-triazine as a curing catalyst and 215.40 g of barium titanate (particle diameter : 1.16 µm) as dielectric ceramics having a high dielectric constant.

Using the obtained thermosetting composite dielectric composition, a thermosetting composite dielectric film was prepared in the same manner as Example 1. The amount of the residual solvent in this thermosetting composite dielectric film was measured in the same manner as Example 1 and was found to be less than 1 wt.%. The content of barium titanate in the thermosetting composite dielectric film was 61.6 volume%.

Further, the thermosetting composite dielectric film and the composite dielectric film resulting from curing of the foregoing thermosetting composite dielectric film had good flexibilities as in Example 1. Furthermore, the dielectric constant and dielectric loss of the thermosetting composite dielectric film were measured in the same manner as Example 1 and the results obtained are shown in Table 1.

### (Example 3)

A thermosetting composite dielectric composition was prepared by stirring, at a room temperature and an atomospheric pressure for 30 minutes using an Ishikawa type stirring crusher, a solution obtained by dissolving 10.09 g of a dicyclopentadiene type epoxy resin (commercial name "EPICLON HP-7200" manufactured by DAINIPPON INK AND CHEMICALS, INCORPORATED, epoxy equivalent : 260) as a thermosetting resin and 26.92 g of a liquid alicyclic epoxy resin (commercial name "EPIKOTE YL6753" manufactured by Japan Epoxy Resins Co., Ltd., epoxy equivalent : 181, viscosity at 25°C : 2.4 Pa·s) as a low-viscosity epoxy resin in 20.05 g of methyl ethyl ketone, 0.38 g of 2,4-diamino-6-(2'-methylimidazolyl-(1'))-ethyl-s-triazine as a curing catalyst and 147.84 g of barium titanate (particle diameter : 1.16 µm) as dielectric ceramics having a high dielectric constant.

Using the obtained thermosetting composite dielectric composition, a thermosetting composite dielectric film was prepared in the same manner as Example 1.

The amount of the residual solvent in that thermosetting composite dielectric film obtained was measured in the same manner as Example 1 and was found to be less than 1 wt.%. The content of barium titanate in the thermosetting composite dielectric film was 42.5 volume%.

Further, the thermosetting composite dielectric film and the composite dielectric film resulting from curing of the foregoing thermosetting composite dielectric film exhibited good flexibilities as in Example 1.

The dielectric constant and dielectric loss of the thermosetting composite dielectric film were measured in the same manner as Example 1 and the results obtained are shown in Table 1.

### (Example 4)

Using a chalcone group-containing bisphenol-epichlorohydrin type epoxy resin (weight average molecular weight : 14000, chalcone group content : 0.7 mole/kg, epoxy content : 0.85 mole/kg, epoxy equivalent : 1176) as a thermosetting resin, a mixed solvent varnish (solid content : 49.12 wt.%, A/B/C = 29/21/50 weight ratio) containing the above resin, diethyleneglycol monomethyl ether (A), dimethylacetamide (B) andmethyl ethyl ketone (C) was prepared. A thermosetting composite dielectric composition was prepared by stirring, at a room temperature and an atomospheric pressure for 30 minutes using an Ishikawa type stirring crusher, 12.59 g of the above mixed solvent varnish, 5.00 g of a liquid alicyclic epoxy resin (commercial name "EPIKOTE YL6753" manufactured by Japan Epoxy Resins Co., Ltd., epoxy equivalent: 181, viscosity at 25°C : 2.4 Pa·s) as a low-viscosity epoxy resin, 0.20 g of 2,4-diamino-6-(2'-methylimidazolyl-(1'))-ethyl-s-triazine as a curing catalyst, 106.69 g of barium titanate (particle diameter : 1.16 µm) as dielectric ceramics having a high dielectric constant and 10.00 g of methyl ethyl ketone.

Using the obtained thermosetting composite dielectric composition, a thermosetting composite dielectric film was prepared in the same manner as Example 1. The amount of the residual solvent was found to be less than 1 wt.%. The content of barium titanate in the thermosetting composite dielectric film was 60.5 volume%.

Further, the thermosetting composite dielectric film and the composite dielectric film resulting from curing of the foregoing thermosetting composite dielectric film exhibited good flexibilities like the composite dielectric films of Example 1.

The dielectric constant and dielectric loss of the thermosetting composite dielectric film were measured in the same manner as Example 1 and the results obtained are shown in Table 1.

Further, a negative photo mask for patterning was put on a thermosetting composite dielectric film before thermal curing that was obtained by the application of the above-described thermosetting composite dielectric composition on the copper plate and followed by drying in the same manner as Example 1. The resultant was thereafter exposed at a quantity of light of 1800 mJ/cm² using a high-pressure mercury lamp (made by Ohku Seisakusho). After the exposure, an unexposed portion was dissolved by being brushed in a 30°C methyldiglycol/γ-butyrolactone (75/25 weight ratio) mixed solvent; patterning was carried out. This fact confirmed that the resulting thermosetting composite dielectric film had photosensitive property and can be patterned by light exposure.

### (Example 5)

A mixed solvent varnish (solid content : 48.78 wt.%, A/B/C = 29/21/50 weight ratio) was prepared by adding a bisphenol-epichlorohydrin type epoxy resin which is the same as that used in Example 4 to a mixed solvent of diethyleneglycol monomethyl ether (A), dimethylacetamide (B) and methyl ethyl ketone (C). A thermosetting composite dielectric composition was prepared by stirring at a room temperature and an atomospheric pressure for 30 minutes using an Ishikawa type stirring crusher, 46.38 g of the above mixed solvent varnish, 2.51 g of a polysulfide-modified epoxy resin (commercial name "FLEP-60" manufactured by Toray Thiokcol Co., Ltd., epoxy equivalent : 280, viscosity at 25°C : 17 Pa·s) as a low-viscosity epoxy resin, 0.47 g of 2,4-diamino-6-(2'-methylimidazolyl-(1'))-ethyl-s-triazine as a curing catalyst, 103.15 g of barium titanate (particle diameter : 1.16 µm) as dielectric ceramics having a high dielectric constant and 10.00 g of methyl ethyl ketone.

Using the obtained thermosetting composite dielectric composition, a thermosetting composite dielectric film was prepared in the same manner as Example 1. The amount of the residual solvent was found to be less than 1 wt.%. The content of barium titanate in the thermosetting composite dielectric film was 45.1 volume%.

Further, the thermosetting composite dielectric film and the composite dielectric film resulting from curing of the foregoing thermosetting composite dielectric film exhibited good flexibilities like the composite dielectric films of Example 1.

The dielectric constant and dielectric loss of the thermosetting composite dielectric film were measured in the same manner as Example 1 and the results obtained are shown in Table 1.

Further, a negative photo mask for patterning was put on a thermosetting composite dielectric film before thermal curing that was obtained by the application of the above-described thermosetting composite dielectric composition on the copper plate and followed by drying in the same manner as Example 1. The resultant was thereafter exposed at a quantity of light of 1800 mJ/cm² using a high-pressure mercury lamp (made by Ohku Seisakusho). After the exposure, an unexposed portion was dissolved by being brushed in a 30°C methyldiglycol/γ-butyrolactone (75/25 weight ratio) mixed solvent; patterning was carried out. This fact confirmed that the resulting thermosetting composite dielectric film had photosensitive property and can be patterned by light exposure.

**Table 1**

| | Example 1 | Example 2 | Example 3 | Example 4 | Example 5 |
|---|---|---|---|---|---|
| Dielectric Constant (1KHz) | 30.36 | 38.70 | 25.37 | 53.61 | 42.83 |
| tanδ (1KHz) (%) | 3.38 | 2.66 | 1.00 | 1.51 | 1.36 |

As Table 1 shows, the composite dielectric films of Examples 1-5 have dielectric constants of 25 or more and dielectric losses of 4 or less.

### (Example 6)

For each of the thermosetting composite dielectric compositions prepared in Examples 1-5, a thermosetting composite dielectric composition was applied with a lip reverse coater to a 25 µm thick polyethylene terephthalate (PET) film having a surface that had been release-treated with silicone and was dried in a tunnel kiln adjusted to 70-90°C. Then a 30 µm thick polyethylene film was laminated onto the resulting layer of the composition and was passed through rollers with an adjusted gap. Hence a thermosetting composite dielectric film was successfully wound up around a plastic pipe 3 inches in diameter. As a result, it has been confirmed that thermosetting composite dielectric films being flexible and easy-to-handle can be produced from the thermosetting composite dielectric compositions prepared in Examples 1-5.

### (Example 7)

For each of the thermosetting composite dielectric compositions prepared in Examples 1-5, a composition was applied with a lip reverse coater to a 18 µm thick copper foil and was dried in a tunnel kiln adjusted to 70-90°C. Then a 30 µm thick polyethylene film was laminated onto the resulting layer of the composition and was passed through rollers with an adjusted gap. Hence a thermosetting composite dielectric film was successfully wound up around a plastic pipe 3 inches in diameter. As a result, it has been confirmed that thermosetting composite dielectric films being flexible and easy-to-handle can be produced from the thermosetting composite dielectric compositions prepared in Examples 1-5.

### (Example 8)

A BGA (ball grid array) package incorporating the thermosetting composite dielectric film obtained in Example 7 (the composite dielectric film made by use of the thermosetting composite dielectric composition of Example 1) as a capacitor component was prepared. The BGA package had a size 30 mm square and had seven dielectric layers including a core (among the seven layers, two layers were made of thermosetting composite dielectric films as built-in capacitors). The number of the external terminals was 400 (each of the numbers of the power source terminals and the ground terminals was 100). The number of the electrodes connected to the semiconductor devices are also the same. The composite dielectric films were 30 µm thick and had about 7.0 nF of capacitance in total.

For comparison, a BGA package similar to that described above except containing as a built-in capacitor no thermosetting composite dielectric film was also prepared.

Each of the BGA packages prepared above was provided with a semiconductor as a switching device. A peak value of ground noises occurring when switching from High to Low simultaneously at a switching frequency of 60 was measured. The measurement was carried out at five connecting electrodes of the semiconductor device. The rate of change of electric current I, caused by switching of one switch, with respect to time, dI/dt, was dI/dt = 50 mA/1 nsec (nanosecond) and the period of switching was set to 10 nsec. This is a switching speed corresponding to 100 MHz of clock frequency. The switching noise was measured. That obtained in the case where a thermosetting composite dielectric film of the present invention was built-in as a capacitor was 0.36 V ± 0.07 V, whereas the switching noise obtained in the case where no capacitor was built-in was 0.81 V ± 0.12 V.

As described above, it has been confirmed that a thermosetting composite dielectric film according to the present invention can be incorporated to a substrate to form a capacitor.

### (Comparative Example 1)

A thermosetting composite dielectric composition was prepared by stirring, at a room temperature and an atomospheric pressure for 30 minutes using an Ishikawa type stirring crusher, a solution obtained by dissolving 14.78 g of a alicyclic epoxy resin (commercial name "Celoxide 2021P" manufactured by DAICEL CHEMICAL INDUSTRIES, LTD., epoxy equivalent : 134, viscosity at 25°C : 0.3 Pa·s) as a thermosetting resin in 20.00 g of methyl ethyl ketone, 0.30 g of 2,4-diamino-6-(2'-methylimidazolyl-(1'))-ethyl-s-triazine as a curing catalyst and 62.83 g of barium titanate (particle diameter : 1.16 µm) as dielectric ceramics having a high dielectric constant.

Using the obtained thermosetting composite dielectric composition, a thermosetting composite dielectric film was prepared in the same manner as Example 1. In the thermosetting composite dielectric film, however, the dielectric ceramics were not dispersed uniformly and that film was not a uniform film. The flexibility of the composite dielectric film before thermal curing and that of the composite dielectric film after thermal curing were evaluated in the same manner as Example 1. As a result, no crack was formed in the film before thermal curing even after bending to 90 degrees, whereas the film after thermal curing was cracked and broken when it was bent to 90 degrees.

Further, the dielectric constant and the dielectric loss were measured in the same manner as Example 1. The dielectric constant and the dielectric loss were 8.28 and 2.17%, respectively. The content of barium titanate in the thermosetting composite dielectric film is 45.3 volume%.

## Claims

1. A thermosetting composite dielectric film having flexibility comprising a thermosetting resin containing dielectric ceramics having a high dielectric constant, wherein the thermosetting composite dielectric film has a dielectric constant of 25 or more.

2. The thermosetting composite dielectric film according to claim 1, wherein said thermosetting resin is an epoxy resin having at least one epoxy group in its molecule.

3. The thermosetting composite dielectric film according to claim 2, wherein said epoxy resin has an epoxy equivalent of 150 to 2500.

4. The thermosetting composite dielectric film according to any one of claims 1 to 3, wherein the content of said dielectric ceramics is from 20 to 70 volume%.

5. The thermosetting composite dielectric film according to any one of claims 1 to 4, wherein said dielectric ceramics has an average particle diameter of 0.1 to 10 µm.

6. The thermosetting composite dielectric film according to any one of claims 2 to 5, wherein said epoxy resin is a bisphenol-epichlorohydrin type epoxy resin having a chalcone group.

7. The thermosetting composite dielectric film according to claim 6, wherein said bisphenol-epichlorohydrin type epoxy resin has a weight average molecular weight of 8000 to 40000.

8. The thermosetting composite dielectric film according to claim 6 or 7, wherein said bisphenol-epichlorohydrin type epoxy resin contains a chalcone group in a content of 0.1 to 1 mole/kg and also contains an epoxy group in a content of 0.5 to 1.5 mole/kg.

9. The thermosetting composite dielectric film according to any one of claims 2 to 8, wherein said epoxy resin contains a low-viscosity epoxy resin.

10. The thermosetting composite dielectric film according to claim 9, wherein said low-viscosity epoxy resin has a viscosity of 1000 Pa·s or lower at 25°C.

11. The thermosetting composite dielectric film according to any one of claims 1 to 10, wherein said dielectric ceramics is barium titanate, strontium titanate, calcium titanate, lead titanate or a mixture thereof.

12. A method for manufacturing a thermosetting composite dielectric film comprising the steps of:
applying a solution of a thermosetting resin containing dielectric ceramics having a high dielectric constant on a base material; and
drying said solution applied on the substrate at a temperature lower than the curing temperature of the thermosetting resin to form a film.

13. The method for manufacturing a thermosetting composite dielectric film according to claim 12, wherein the thermosetting composite dielectric film according to any one of claims 1 to 11 is manufactured.

14. A thermosetting resin composition for forming a composite dielectric film, the composition comprising:
an epoxy resin having an epoxy equivalent of 150 to 2500; and
dielectric ceramics having a high dielectric constant and having an average particle diameter of 0.1 to 10 µm;
the content of said dielectric ceramics in said epoxy resin being from 20 to 70 volume%.

15. The thermosetting resin composition for forming a composite dielectric film according to claim 14, wherein said epoxy resin is a bisphenol-epichlorohydrin type epoxy resin having a chalcone group and having a weight average molecular weight of 8000 to 40000.

16. The thermosetting resin composition for forming a composite dielectric film according to claim 14 or 15, wherein said epoxy resin contains an epoxy resin that has a viscosity of 1000 Pa·s or lower at 25°C.

17. The thermosetting resin composition for forming a composite dielectric film according to any one of claims 14 to 16, wherein said dielectric ceramics having a high dielectric constant is barium titanate, strontium titanate, calcium titanate, lead titanate or a mixture thereof.
